# EUROPEAN PATENT APPLICATION

(11) **EP 2 312 302 A1**
(43) Date of publication of application: **20.04.2011**
(21) Application number: 10250397.6
(22) Date of filing: 05.03.2010
(51) Int. Cl.: G01N 23/225, H01J 37/28

(54) **Apparatus and method for inspecting samples**

(30) Priority: 26.03.2009 JP 2009076908
(71) Applicant: Jeol System Technology Co., Ltd., Akishima, Tokyo 196-8558 (JP)
(72) Inventor: Nishiyama, Hidetoshi, Higashiyamato Tokyo, 2070022 (JP); Koizumi, Mitsuru, Tokyo, 192-0031 (JP); Suga, Mitsuo, Saitama, 343-0821 (JP)
(74) Representative: Cross, Rupert Edward Blount

(57) **Abstract**

An inspection apparatus and method capable of well observing or inspecting a specimen (20) contained in a liquid. Maintenance of the apparatus can be improved. The inspection apparatus has a film (32) including first (32a) and second (32b) surfaces. Furthermore, the apparatus has a vacuum chamber (11) for reducing the pressure in the ambient in contact with the second surface (32b) of the film, primary beam irradiation means (2) connected with the vacuum chamber (11), and a shutter (4) for partially partitioning the space between the film (32) and the primary beam irradiation means (2) within the vacuum chamber (11). A liquid sample (20) is held on the first surface of the film. The primary beam irradiation means (2) irradiates the sample with a primary beam (7) through the film (32). Backscattered electrons (a secondary beam) (61) produced from the sample by the primary beam irradiation are directed at the shutter (4), producing secondary electrons (a tertiary signal) (62). The secondary electrons (62) are detected by a detector (16) . The apparatus further includes a vacuum gauge (15) for detecting the pressure inside the vacuum chamber (11).

## Description

### BACKGROUND OF THE INVENTION

### 1. Field of the Invention

The present invention relates to apparatus and method permitting good observation or inspection either of a specimen contained in a liquid or of a sample consisting of biological cells which have been cultured and are present in a liquid culture medium.

### 2. Description of the Related Art

We living organisms are multicellular animals and develop diseases if information cannot be transmitted normally among cells or if viruses or chemical substances cling to cells. For this reason, in the fields of molecular biology and pharmaceutics, research is conducted by peeling off cells from a living organism, cultivating the cells on a laboratory dish, giving a stimulus such as electricity, chemical substance, or medicine to the cells, and observing the resulting reaction on the cellular level. In the past, optical microscopes have been used for such observations. Manipulators or pipettes have been employed to give stimuli to cells. Frequently, important portions to be observed are very tiny regions of less than 0.1 µm that are impossible to observe with an optical microscope.

For example, diseases arising from inability to exchange substances normally among biological cells include hypertension, diabetes insipidus, arrhythmia, myopathy, diabetes, and deprementia. Exchange of substances among cells is performed by ion channels having sizes of about 10 nm and existing in cell membranes. Because it is difficult to observe such ion channels with optical microscopes, there has been a demand for a technique enabling observation using a scanning electron microscope (SEM) having high resolution.

However, a sample to be inspected with an inspection apparatus incorporating SEM capabilities is normally placed in a sample chamber whose internal pressure has been reduced by vacuum pumping. The sample placed in the sample chamber, which in turn is placed in a reduced-pressure ambient in this way, is irradiated with an electron beam (charged particle beam). Secondary signals such as secondary electrons or backscattered electrons produced from the sample in response to the irradiation are detected. In such inspection of a sample using SEM, the sample is exposed to a reduced-pressure ambient. Therefore, moisture evaporates from the sample, so that the cells die. It has been impossible to observe reactions of living cells to a stimulus.

When a sample consisting of dead cells where the proteins have been fixed is placed in a vacuum, much labor and various pretreatments such as dehydration, drying, and metal vapor deposition that require a high degree of skillfulness have been necessary to prevent evaporation of moisture within a vacuum; otherwise, the sample would be deformed. Accordingly, an exorbitantly long time has been required to observe the sample. It has been impossible to achieve high throughput observations.

Accordingly, when an inspection is performed under the condition where the sample contains moisture, it is necessary to prevent the sample from being exposed to the reduced-pressure ambient; otherwise, moisture would evaporate from the sample. One conceivable method of inspecting a sample using SEM without exposing the sample to a reduced-pressure ambient in this way consists of preparing a sample holder (sample capsule that may or may not be hermetically sealed) whose opening (aperture) has been sealed off by a film, placing the sample in the holder, and installing the holder in an SEM sample chamber that is placed in the reduced-pressure ambient.

The inside of the sample holder in which the sample is placed is not evacuated. The film that covers the opening formed in the sample capsule can withstand the pressure difference between the reduced-pressure ambient inside the SEM sample chamber and the ambient (e.g., atmospheric-pressure ambient) of the inside of the sample holder that is not pumped down. Furthermore, the film permits an electron beam to pass therethrough (see patent document 1).

When a sample is inspected, a culture medium is first put into a sample capsule together with cells. The cells are cultivated on the film. Then, the sample capsule is placed into an SEM sample chamber that is in a reduced-pressure ambient. An electron beam is directed at the sample placed within the sample capsule from outside the capsule via the film on the capsule. Backscattered electrons are produced from the irradiated sample. The backscattered electrons pass through the film on the capsule and are detected by a backscattered electron detector mounted in the SEM sample chamber. Consequently, an SEM image is derived.

However, with this technique, the sample is sealed in the closed space and so it has been impossible to give a stimulus (such as application of a voltage or administration of a test reagent) to cells using a manipulator or pipette. The amount of the culture medium put into the sample capsule is about 15 µℓ. Therefore, as the culture medium evaporates, the salinity concentration rises, making it difficult to culture cells. Where the cells should be observed or inspected in vivo, there arises a problem. This problem can be solved by increasing the size of the sample capsule to increase the capacity. However, if the film is destroyed either by stimulation induced by an electron beam or by a mechanical stimulus, a new problem is created. That is, the culture medium flows out in quantity, thus contaminating the inside of the apparatus.

An example of a method of obtaining an SEM image by preparing a film withstanding the pressure difference between vacuum and atmospheric pressure, irradiating a sample with an electron beam via the film, and detecting backscattered electrons produced from the sample in this way is described also innon-patent document 1 (especially, Chapter 1: Introduction).

Examples in which two films of the structure described above are placed opposite to each other with a sample interposed between the films and in which an image is acquired by a transmission electron microscope are described in patent documents 2 and 3. Especially, patent document 2 also states a case in which an SEM image of the sample interposed between such films is acquired.

Patent document 4 discloses a sample inspection apparatus equipped with an open-close valve for preventing contamination of the inside of a vacuum chamber when a film holding a sample containing moisture is destroyed.
[Patent document 1] JP-T-2004-515049
[Patent document 2] JP-A-47-24961
[Patent document 3] JP-A-6-318445
[Patent document 4] JP-A-2007-292702
[Non-patent document 1] "Atmospheric scanning electron microscopy", Green, Evan Drake Harriman, Ph.D., Stanford University, 1993

The resolution of an optical microscope is not high enough to observe very tiny regions of biological cells. High-resolution imaging using SEM is necessary. In order to observe cells by SEM while maintaining the liquid, a specimen (cells) cultured on a laboratory dish is sealed into a sample capsule in the prior art. The specimen is irradiated with an electron beam via the film formed on the sample capsule. Thus, the specimen is imaged.

However, the sample capsule is a narrow closed space. Therefore, there is the problem that it has been impossible to observe the state of the specimen immediately after a stimulus is given (e. g. , application of a voltage or administration of a test reagent) from the outside to the specimen using a manipulator or pipette. Furthermore, the internal capacity of the sample capsule is small. Consequently, when moisture evaporates and the salinity concentration rises, it is difficult to culture cells for a long time inside the sample capsule. Hence, there are problems in observing cells for a long time.

Accordingly, an SEM free of these problems has been developed. In particular, a sample containing a liquid is held on a sample-holding surface (upper surface) of a film while the sample is open in an ordinary-pressure state. The ambient in contact with the lower surface of the film facing away from the sample-holding surface is placed in a reduced-pressure state. An electron beam can be directed via the film at the sample from the ambient in the reduced-pressure state. In this SEM, the sample held on the sample-holding surface of the film is open and so access using a manipulator, pipette, or the like is permitted (see patent document 4).

However, in the SEM of this structure, the film may be destroyed due to the difference in pressure between the upper and lower surfaces of the film. In the SEM configuration described in patent document 4, the open-close valve for partitioning off the space between the primary beam irradiation means and the film within the vacuum chamber is mounted to the apparatus. If the film is destroyed, the valve is closed. However, when the valve is closed in this way, the inside of the vacuum chamber is partitioned off completely. Therefore, it takes a long time to achieve this closing operation, thus presenting a problem.

### SUMMARY OF THE INVENTION

In view of the foregoing, the present invention has been made. It would be desirable to provide apparatus and method for inspecting a sample, the apparatus having a shutter capable of partially partitioning the inside of a vacuum chamber. The apparatus can detect a tertiary signal produced from the shutter when a secondary beam emanating from the sample reaches the shutter. An image of the specimen is obtained based on the detected tertiary signal. In consequence, the shutter is closed quickly. This facilitates maintaining the apparatus. In addition, the shutter can be fabricated at lower cost.

An inspection apparatus according to one embodiment of the present invention has: a film including a first surface on which a sample is to be held; a vacuum chamber for reducing the pressure in an ambient in contact with a second surface of the film; primary beam irradiation means for irradiating the sample held on the film with a primary beam via the film, the primary beam irradiation means being connected with the vacuum chamber; a shutter located between the film and the primary beam irradiation means in the vacuum chamber and configured to pass the primary beam coming from the primary beam irradiation means, the shutter partially partitioning the space between the film and the primary beam irradiation means in the vacuum chamber; and signal detection means for detecting a tertiary signal produced from the shutter when a secondary beam emanating from the sample in response to the primary beam passes through the film and reaches the shutter.

In one inspection method according to the present invention, the sample is inspected with the inspection apparatus.

Another inspection method according to the invention includes the steps of: holding a sample on a first surface of a film; reducing the pressure of an ambient in contact with a second surface of the film; irradiating the sample with a primary beam using primary beam irradiation means from a side of the second surface of the film via the film; causing a secondary beam produced from the sample in response to the primary beam irradiation to be directed at a shutter that partially partitions the space between the film and the primary beam irradiation means; and detecting a tertiary signal produced concomitantly from the shutter.

In the above-described apparatus and method for inspection, the shutter may be provided with a hole such that the shutter is configured to pass the primary beam as described previously. The shutter may have a receiver dish which, when the film is destroyed, receives the sample flowing into the vacuum chamber. The first surface may hold the sample while in an open state to permit access to the sample. There may be further provided destruction detection means for detecting destruction of the film. The apparatus has a function of automatically actuating the shutter to partially partition the space. The destruction detection means detects a rise in the pressure in the vacuum chamber caused by destruction of the film. The first surface of the film may be the upper surface of the film, while the second surface of the film may be the lower surface of the film.

The aforementioned primary beam is a charged particle beam or an electron beam. The secondary beam is at least one of secondary electrons, backscattered electrons, X-rays, and cathodoluminescent light. The aforementioned tertiary signal is at least one type of secondary electrons, backscattered electrons, X-rays, and cathodoluminescent light.

The present invention pertains to an apparatus and method as described above. The apparatus can be maintained easily.

Advantageously, the shutter producing the tertiary signal acts also to partially partition off the space between the film and the primary beam irradiation means within the vacuum chamber. Consequently, if the film is broken and the sample held on the film flows into the vacuum chamber, the shutter quickly partitions the primary beam irradiation means and the film from each other. This can prevent the primary beam irradiation means from being contaminated with the sample. In this case, the shutter become contaminated but it may be cleaned or replaced.

Because the shutter is simple in structure, the cost can be reduced. In the past, whenever the film was damaged, the inside of the apparatus needed to be cleaned. The present invention facilitates or dispenses with the cleaning (using part replacement).

Other features and advantages of the present invention will become apparent from the following more detailed description, taken in conjunction with the accompanying drawings, which illustrate, by way of example, the principles of the invention.

### BRIEF DESCRIPTION OF THE DRAWINGS

Fig. 1 is a schematic block diagram of a first embodiment of a sample inspection apparatus according to the present invention, and in which the shutter is open;
Fig. 2 is a schematic diagram showing the first embodiment of the sample inspection apparatus according to the invention, and in which the shutter is also open;
Fig. 3 is a schematic block diagram similar to Fig. 1, but in which the shutter is closed;
Fig. 4 is a cross-sectional view of a sample holder according to the invention, showing its structure;
Fig. 5 is a schematic perspective view of a frame-like member constituting the sample holder according to the invention; and
Fig. 6 shows sequential cross sections illustrating a method by which the frame-like member constituting the sample holder according to the invention is fabricated.

### DETAILED DESCRIPTION OF THE INVENTION

Apparatus and method for inspection in accordance with the present invention are hereinafter described with reference to the drawings.

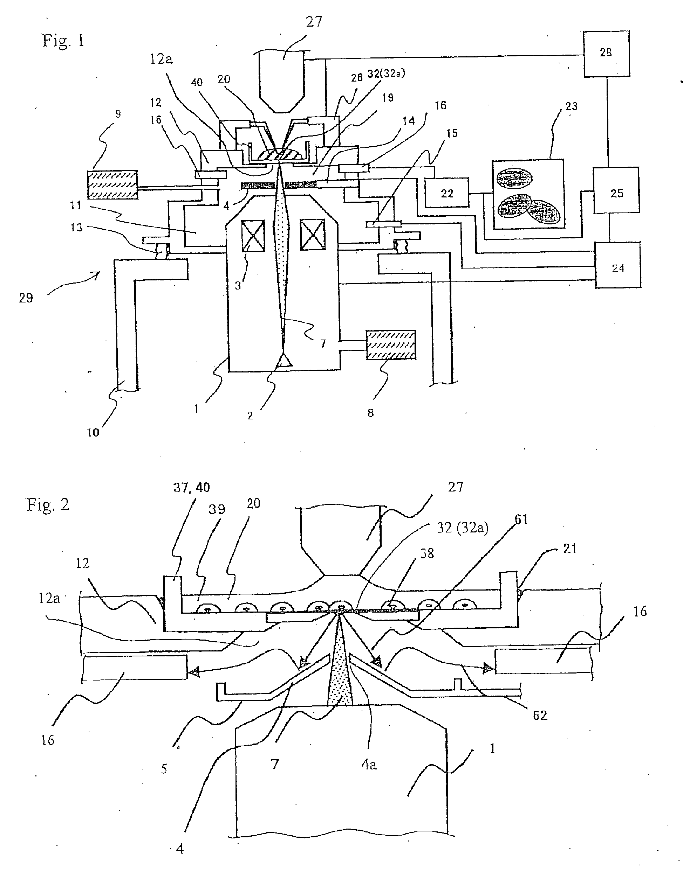

Fig. 1 is a schematic block diagram showing a first embodiment of a sample inspection apparatus according to the present invention. The apparatus consists chiefly of an optical microscope 27, a manipulator 26, and an electron beam apparatus section 29 located under a sample holder 40.

In Fig. 1, an electron gun 2 forming an electron source is disposed in an electron optical column 1 constituting primary beam irradiation means. The gun 2 emits an accelerated electron beam (charged particle beam) 7 upwardly, the beam being a primary beam. The beam 7 is focused by a condenser lens (objective lens) 3.

The focused electron beam 7 is directed at a liquid sample 20 via a sample-holding film 32 (described later) formed on the sample holder 40. The sample 20 is held on the sample holder 40. In the present embodiment, the liquid sample 20 includes biological cells 38 (to be inspected) and a culture medium 39 as shown in Fig. 2.

The front-end side of the electron optical column 1 is connected with a vacuum chamber 11. The electron gun 2 is mounted in the base side of the electron optical column 1. The base side of the column 1 is locatedunder the vacuum chamber 11. Because of this configuration, the electron beam 7 released from the electron gun 2 travels upward through the optical column 1, passes through the space inside the vacuum chamber 11 and through the sample-holding film 32, and reaches the liquid sample 20.

During the irradiation, the electron beam 7 is deflected by deflection means (not shown). Thus, the beam 7 scans the sample 20. At this time, the specimen (such as cells) contained in the liquid sample 20 is also scanned with the beam 7.

The electron optical column 1 forms the primary beam irradiation means in this way. In the present embodiment, the electron optical column is of the inverted type. A shutter 4 is mounted at the front-end side of the column 1 within the vacuum chamber 11.

Fig. 2 is an enlarged view of the vicinities of the portion of the apparatus where the shutter 4 is located. Specifically, the shutter 4 is placed in the position where backscattered electrons 61 produced from the liquid sample 20 (including the cells 38 and culture medium 39) reach when the sample 20 is irradiated with the beam 7. When the backscattered electrons 61 hit the shutter 4, secondary electrons 62 are produced from the shutter 4. The shutter 4 is preferably coated on its surface with gold or magnesium oxide to promote generation of the secondary electrons 62.

The shutter 4 is provided with a hole 4a permitting passage of the electron beam 7. Under the condition shown in Figs. 1 and 2, the shutter 4 is placed in the position where it is open within the vacuum chamber 11. The hole 4a in the shutter 4 is located in the path of the beam 7 released from the electron optical column 1. Consequently, the beam 7 from the column passes through the hole 4a and reaches the sample 20 through the sample-holding film 32.

The secondary electrons 61 produced at the shutter 4 are detected by a detector 16, which is made, for example, of a semiconductor detector making use of a PN junction or of a scintillator detector using a YAG crystal.

Referring back to Fig. 1, the detection signal from the detector 16 is fed to an image formation device 22 disposed outside the vacuum chamber 11. The image formation device 22 creates image data based on the detection signal. The image data corresponds to an SEM image of the specimen. The image data is sent to a display device 23. An image based on the image data sent in is displayed on the display device 23. The displayed image is an SEM image.

Image data created by the image formation device 22 is also sent to a computer 25 according to the need. The computer 25 performs image processing on the image data and carries out a decision on the specimen based on the result of the image processing.

The inside of the electron optical column 1 is pumped down to a desired pressure by first vacuum pumping means 8. The inside of the vacuum chamber 11 is evacuated to a desired pressure by second vacuum pumping means 9. The vacuum chamber 11 is placed over a pedestal 10 via a vibration-proofing device 13.

A sample holder support 12 is mounted on top of the vacuum chamber 11 and provided with a hole 12a through which the electron beam 7 is directed at the sample-holding film 32. The sample holder 40 is placed on the holder support 12 via an O-ring 21 (Fig. 2). Consequently, the sample holder 40 is withdrawably supported in the vacuum chamber 11.

A vacuum gauge 15 for detecting the pressure inside the vacuum chamber 11 is mounted in the vacuum chamber 11. The shutter 4 is mounted between the front end of the electron optical column 1 and the sample-holding film 32 as described previously. A shutter actuator 14 that is open in the state of Figs. 1 and 2 operates to move (close) the shutter 4 into the path of the electron beam 7 traveling from the electron optical column 1 toward the sample-holding film 32 within the vacuum chamber 11, thus blocking the path.

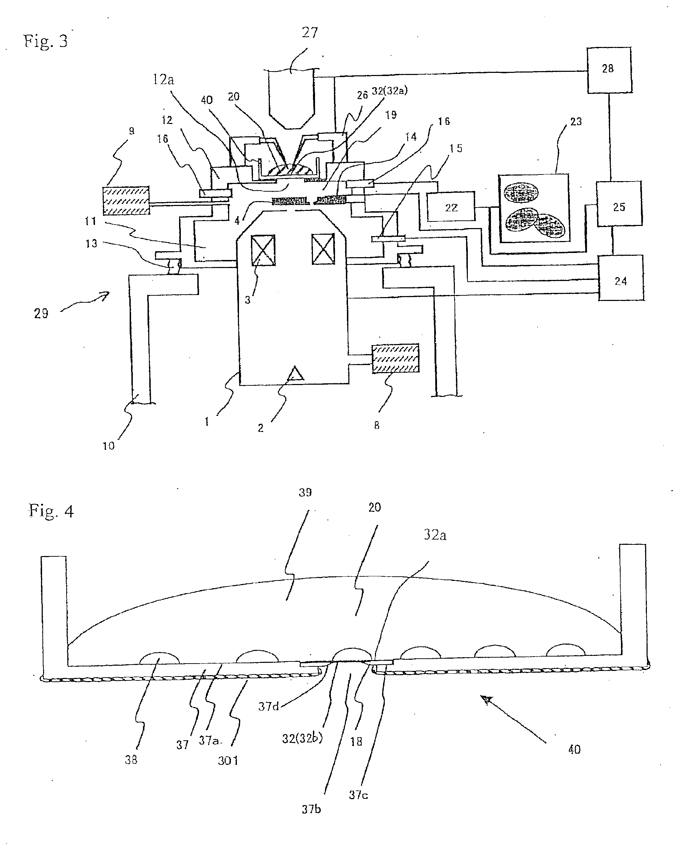

The shutter actuator 14 automatically moves as shown in Fig. 3 to block the path of the beam 7 when the sample-holding film 32 is destroyed and the vacuum gauge 15 detects a given rise in the pressure. For example, when the sample-holding film 32 is destroyed and the liquid sample 20 flows into the vacuum chamber 11 to thereby make the pressure inside the vacuum chamber higher than 100 Pa, the shutter actuator 14 is operated as shown in Fig. 3. In consequence, the liquid sample 20 entering the vacuum chamber 11 can be received and stopped by the shutter 4. Hence, contamination of the electron optical column 1 and detector 16 is prevented. If the shutter 4 is fitted with a receiver dish 5 for receiving the liquid sample as shown in Fig. 2, then it is possible to cope with inflow of a large amount of liquid sample.

The shutter 4 partitions the vacuum chamber 11 into two vertically separated portions partially rather than completely. Therefore, the shutter is simple in structure and can be operated at high speed. In the present embodiment, the vacuum gauge 15 detects a rise in the pressure. After a lapse of 0.1 second, the shutter is set into operation to bring the shutter from the state of Fig. 1 to the state of Fig. 3.

The shutter 4 can be thinned. This reduces the distance between the front end of the column 1 and the sample-holding film 32 (i.e., the working distance of the SEM). As a result, a higher resolution can be accomplished.

The electron beam apparatus section 29 equipped with the electron optical column 1 and the vacuum chamber 11 also includes the shutter 4, shutter actuator 14, vacuum gauge 15, and detector 16. The apparatus section 29 is under control of an electron beam controller 24. Placed on the sample holder support 12 are the manipulator 26 for giving a stimulus (such as voltage, chemical substance, or medicine) to the liquid sample 20 including the specimen to be inspected and the optical microscope 27 permitting one to observe the sample 20 or check the position of the manipulator 26. The manipulator 26 moves the sample according to the need. These components are controlled by an overall controller 28.

The optical axis of the optical microscope 27 is coincident with the optical axis of the electron beam 7. Alternatively, the center of field of view of the optical microscope 27 is coincident with the center of field of view of the SEM image. A region observed by the optical microscope can be made substantially coincident with the SEM image. The field of view of the SEM image and the field of view of the optical microscope 27 can be adjusted by manipulating the manipulator 26 or moving the sample holder support 12 on which the sample holder 40 is placed by means of a moving mechanism (not shown).

The inspection apparatus according to the present invention has the electron beam apparatus section 29, manipulator 26, optical microscope 27, electron beam controller 24, overall controller 28, image formation device 22, and display device 23. These portions are connected with the computer 25. Information can be exchanged between these portions.

The sample holder 40 is constructed as shown in Fig. 4. The sample holder 40 is composed of a dish-like body portion 37 made of plastic or glass and a film holder (frame-like member) 18 on which the sample-holding film 32 is formed. The film 32 transmits the electron beam 7. A recessed portion is formed inside the body portion 37. The bottom surface of the recessed portion forms a sample-holding surface 37a that is open.

The sample-holding surface 37a of the body portion 37 is (centrally in the example of Fig. 4) provided with a through-hole 37b. A step portion 37c is formed around the hole 37b on the side of the sample-holding surface 37a. The film holder 18 is disposed on the step portion 37c and has the sample-holding film 32. The sample-holding film 32 has a first surface 32a that forms the sample-holding surface 37a. The first surface 32a of the film 32 is substantially flush with the sample-holding surface 37a of the body portion 37. Consequently, at least a part of the sample-holding surface 37a of the sample holder 40 is formed by the sample-holding film 32.

Tapering portions 37d are formed on the side of the hole 37b on the opposite side of the sample-holding surface 37a. The tapering portions 37d are spread apart toward the surface on the opposite side of the sample-holding surface 37a. The spread angle is set to 90° to 120°.

A region of the lower surface of the sample holder 40 might be exposed to a vacuum ambient and become irradiated with the electron beam 7. A conductive film 301 is formed on this region to prevent charging of the sample holder 40 when it is irradiated with the beam 7. The conductive film 301 is in contact with the film holder 18. Electric charge accumulated by being irradiated by the electron beam 7 can be dissipated away to the liquid sample 20 via the film holder 18 made of silicon. The presence of the conductive film 301 reduces the charging of the lower surface of the sample holder 40 and can prevent displacement of the orbit of the beam 7 (that would normally be produced when the liquid sample 20 is illuminated with the beam 7) and distortion and illumination spots in the SEM image that would be normally produced by displacement of the orbit of backscattered electrons.

Accumulation of electric charge can be prevented effectively by connecting a grounding line to the liquid sample 20 or electrically connecting the conductive film 301 with the sample holder support 12. The conductive film 301 can be formed, for example, by vapor-depositing or sputter-depositing aluminum, gold, or indium tin oxide (ITO) or by applying silver paste.

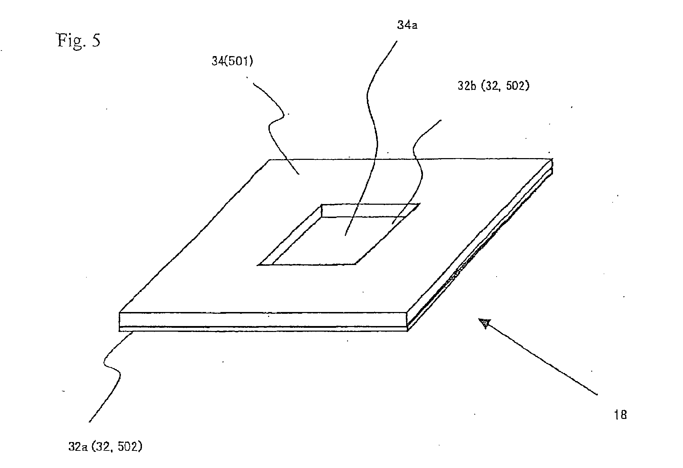

The structure of the film holder 18 is shown in Fig. 5. The sample-holding film 32 is formed on a silicon substrate 34. The first surface 32a of the sample-holding film 32 (lower surface as viewed in Fig. 5; upper surface as viewed in Fig. 4) is exposed. The liquid sample 20 containing liquid 39 such as a culture medium and cells 38 (specimen to be inspected) is placed on the first surface (sample-holding surface) 32a of the sample-holding film 32. Since the first surface 32a is under atmospheric pressure, evaporation of moisture from the liquid sample 20 can be suppressed to a minimum.

The silicon substrate 34 is centrally provided with an opening 34a (upper surface in Fig. 5; lower surface in Figs. 1 and 4) covered with the sample-holding film 32. A central portion of the second surface 32b of the sample-holding film 32 is exposed to the inside ambient of the vacuum chamber 11 through the opening 34a.

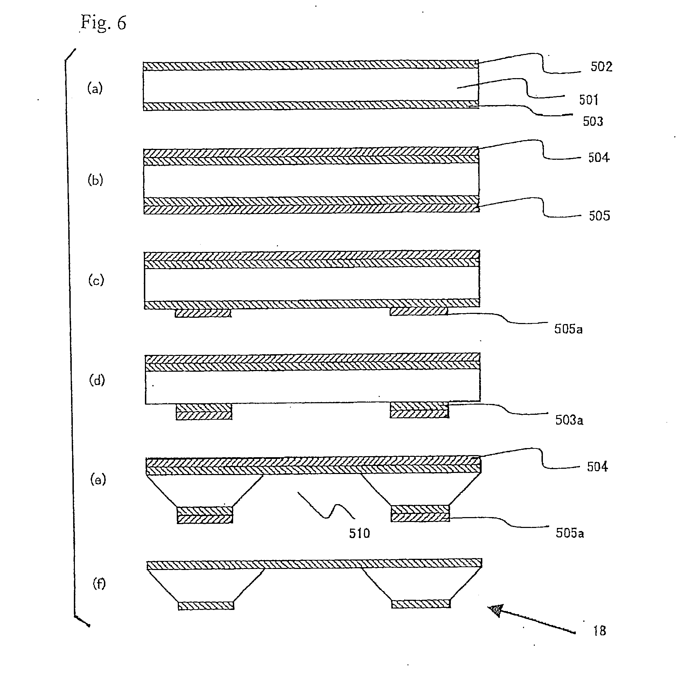

A method of creating the film holder 18 is next described by referring to Fig. 6. First, as shown Fig. 6(a), silicon nitride films 502 and 503 are formed on a silicon substrate 501 using CVD (chemical vapor deposition). A typical thickness of the films 502 and 503 is 30 nm. Layers of resist 504 and 505 are applied on the silicon nitride films 502 and 503, respectively (Fig. 6(b)). The layer of resist 505 is patterned photolithographically to leave behind resist layer portions 505a (Fig. 6(c)). Using the resist pattern as a mask, the silicon nitride film 503 is processed by dry etching, and silicon nitride film portions 503a are left behind (Fig. 6(d)). Using the pattern as a mask, the silicon substrate 501 is wet-etched with KOH to form an opening 510 (Fig. 6(e)). The resist layer portions 504 and 505a are removed by ashing (Fig. 6(f)), thus completing the film holder 18.

The film holder 18 fabricated in this way is inverted up and down from the state of Fig. 5. The first surface 32a of the silicon nitride film 502 that is the sample-holding film 32 is taken as an upper surface. The second surface 32b can also be taken as an upper surface.

The film holder 18 is firmly attached to the step portion 37c over the hole 37b formed in the body portion 37 forming the sample holder 40. Thus, the sample holder 40 is fabricated (Fig. 4). To attach the holder 18 to the step portion firmly, bonding using an epoxy-based or silicone-based adhesive or fusion making use of heat, ultrasonic waves, or laser light can be used. Consequently, the film holder 18 is firmly held in a position corresponding to the hole 37b in the sample-holding surface 37a of the body portion 37.

In the present embodiment, the body portion 37 of the sample holder and film holder 18 are combined to fabricate the sample holder 40. The sample-holding film 32 may be directly firmly bonded to the body portion 37. The body portion 37 and the sample-holding film 32 may be fabricated integrally. Furthermore, cell adhesion molecules (described later) acting as molecules for bonding the sample may be applied to the sample-holding surface 37a including the first surface 32a of the sample-holding film 32.

The thickness of the silicon nitride film 502 is set within a range of from 10 to 1,000 nm. The sample-holding film 32 of the film holder 18 is made of silicon nitride. In addition, the film 32 may be made of silicon oxide, boron nitride, polymer, polyethylene, polyimide, polypropylene, or carbon. Where films of these materials are used, their thicknesses are set within a range of from 10 to 1,000 nm. The sample-holding film 32 made of the aforementioned material transmits the electron beam 7 but does not transmit gas or liquid. Moreover, it is necessary that the film be capable of withstanding a pressure difference of at least 1 atmosphere across the opposite surfaces. As the thickness of the sample-holding film 32 is reduced, scattering of the electron beam 7 is reduced and, therefore, the resolution is improved but the film is more easily damaged. As the thickness is increased, scattering of the electron beam 7 increases, resulting in decreased resolution. However, the film is less likely to be damaged. The preferable thickness of the film is 20 to 200 nm.

An inspection method according to the present invention is next described. First, as shown in Fig. 4, the cells 38 forming a specimen to be inspected are cultured within the culture medium 39 using the sample holder 40. In order to culture the cells 38 in this way, it is necessary to graft the cells from the laboratory dish where they have been previously cultured to the sample holder 40. For this purpose, a normal method as described below is used.

The culture medium is Product No. D5796 of Sigma-Aldrich Co., for example. First, the culture medium is discarded from within the laboratory dish where the cells have been previously cultured. A mixture liquid of trypsin and EDTA (ethylenediaminetetraacetic acid) is put into the dish to peel off the cells adsorbed to the dish. The peeled cells are then recovered into a centrifuge tube. A culture medium is added to the cells. The trypsin is inactivated and then the cells are spun down. Then, the supernatant fluid is discarded from within the centrifuge tube and the remaining liquid is stirred in the culture medium. A part (e.g., 1/10) of the stirred liquid including the cells 38 is entered into the sample holder 40. Further culture medium (liquid sample) 39 is added.

Under this condition, the holder is allowed to stand still in a cell culture chamber. After a lapse of several hours, the cells 38 begin to adsorb onto the sample-holding surface 37a of the sample holder 40 including the surface 32a of the sample-holding film 32 and proliferate. The aforementioned method may be modified according to cells, and is shown merely as an example. Consequently, the cells 38 which are to be observed or inspected and become a specimen to be inspected are cultured within the sample holder 40. It follows that the liquid sample 20 containing the cultured cells 38 and culture medium 39 is constituted.

Depending on biological cells, if cell adhesion molecules (molecules for bonding of the sample) are applied to the sample-holding surface 37a of the sample holder 40 (especially, the first surface (sample-holding surface) 32a of the sample-holding film 32 observed with an electron beam), cultivation is facilitated. The cell adhesion molecules cause cells arranged for cultivation and cells proliferated by cultivation to be adsorbed onto the sample-holding surface. Examples of the cell adhesion molecules include collagen, fibronectin, vitronetin, cadherin, integrin, claudins, desmogleins, neuroligin, neurexin, selectin, laminins, and poly-L-lysine.

After the cells are cultured within the sample holder 40 as described above, the sample holder 40 is placed on the holder support 12. At this time, the shutter 4 is closed and in the state of Fig. 3. Subsequently, the insides of the vacuum chamber 11 and electron optical column 1 are evacuated to desired degrees of vacuum using the vacuum pumping means 8 and 9. For example, the pressure inside of the vacuum chamber 11 is set to about 1 Pa. The pressure inside the electron optical column 1 (especially, around the electron gun 2) is set to about 10⁻⁴ to 10⁻⁵ Pa, for example.

The positions of the cells 38 and of the manipulator 26 are then checked with the optical microscope 27. A glass microtube holding microelectrodes therein is installed at the front end of the manipulator. A voltage can be applied to the cells through the microelectrodes. A liquid can be made to flow in and out through the glass microtube.

Under this condition, the manipulator 26 is moved while making an observation with the optical microscope 27 to bring the cells 38 close to the glass microtube. Then, a negative pressure is applied to the glass microtube to bring it into intimate contact with the cell membranes. As a result, an electric potential response can be measured.

When the manipulator 26 is moved as described above, if the sample-holding film 32 is erroneously damaged and the liquid sample 20 flows into the vacuum chamber 11, the liquid sample 20 can be received and stopped by the shutter 4 because it is closed. Consequently, the inside of the electron optical column 1 is not contaminated. Especially, where the shutter 4 is closed, the liquid sample 20 can be received and stopped by the receiver dish 5 located immediately below the sample-holding film 32 and, therefore, it is assured that the sample 20 can be received and stopped. Contamination of the inside of the vacuum chamber 11 can be suppressed to a minimum. Heretofore, such a mechanism has been unavailable and, therefore, the liquid sample 20 would have entered the electron optical column 1, necessitating cleaning of the inside of the column. The apparatus would have at times been made unusable.

We now return to the observation sequence. After checking that the sample-holding film 32 on which the liquid sample 20 is placed has not been destroyed, the shutter 4 is opened as shown in Figs. 1 and 2, unblocking the path of the electronbeam 7. Under this condition, the electron beam 7 released from the electron optical column 1 within the vacuum chamber 11 can pass through the hole 4a in the shutter 4 and reach the sample-holding film 32. Consequently, it is ready to illuminate the sample 20 with the beam 7 via the sample-holding film 32.

Thereafter, in order to prevent light from entering the detector 16 (such as a backscattered electron detector) via the sample-holding film 32, the light illumination of the optical microscope 27 is ceased. Other extraneous light is blocked in a manner not shown. The blocking also shields the film holder 18 and liquid sample 20 against radiation produced when the electron beam 7 hits the film holder 18 and sample 20.

Then, as shown in Figs. 1 and 2, the electron beam 7 is directed at the liquid sample 20 including the cells 38 from the electron optical column 1 to perform imaging. The beam 7 passes through the sample-holding film 32 of the sample holder 40 and hits the cells 38 forming the specimen to be detected. Backscattered electrons produced from the cells 38 in response to the illumination are directed as a secondary beam at the shutter 4, resulting in the secondary electrons 62, or a tertiary signal. The secondary electrons 62 are detected by the detector 16.

Since the aforementioned tapering portions 37d are formed around the hole 37b of the body portion 37 forming the sample holder 40, collision of the backscattered electrons against the inner side surface of the hole 37b can be suppressed to a minimum. That is, the backscattered electrons can be suppressed from being blocked. Consequently, the number of backscattered electrons 61 hitting the shutter 4 can be increased.

A detection signal produced from the detector 16 is fed to the image formation device 22, which in turn forms image data based on the detection signal. Based on the image data, an image (SEM image) is displayed on the display device 23.

Subsequently, an electrical stimulus is given to the cells 38 using the microelectrodes installed at the front end of the manipulator 26. An SEM image is acquired in the same way as in the above-described process step. The response of the cells 38 to the stimulus is checked.

After the imaging, the shutter 4 is closed as shown in Fig. 3 to prevent contamination of the electron optical column 1 if the sample-holding film 32 should be damaged. Before a variation caused by application of a stimulus to the cells 38 is observed by SEM as described above, an observation may be made with the optical microscope 2 7. Also, at this time, if the shutter 4 is closed, riskof contamination occurring when the sample-holding film 32 is broken can be reduced. That is, when the liquid sample 20 is not irradiated with the electron beam 7, the shutter 4 is closed to prevent the contamination of the inside of the apparatus.

The manipulator 26 can have a mechanism capable of spraying a chemical substance or medicine into the liquid sample 20. Behavior of the cells 38 in response to the chemical substance or medicine can be observed or inspected while observing the cells by SEM. Furthermore, a function of permitting a liquid to flow out can be imparted to the manipulator 26. This permits the sprayed substance to be recovered. Also, the pH of the culture medium and the osmotic pressure can be maintained constant.

In the foregoing, backscattered electrons from the specimen are used as a secondary beam (secondary signal) to form an image. Backscattered electrons produce a signal intensity proportional to the atomic number. Therefore, where the specimen is almost totally made of substances of low atomic numbers such as a biological specimen, the image contrast is very low, and it is difficult to improve the resolution. Accordingly, a heavy metal such as gold may be adsorbed onto portions of the cells 38 to be noticed in their behavior. In particular, gold is adsorbed onto the portions (antigen) via an antibody by causing the antigen tagged with gold particles having the nature of being adsorbed on the portions (antigen) to be sprayed against the cells by making use of an antigen-antibody reaction. Furthermore, a fluorescent dye or quantum dots (e.g., nanoparticles of Si or particles of CdSe coated with ZnS and having sizes of 10 to 20 nm) that emit light when irradiated with an electron beam may be previously adsorbed onto certain portions of the cells 38, and the emitted light may be observed with the optical microscope.

In the above embodiment, normally used gold particles have particle diameters of 10 to 30 nm. However, the adsorptive force between the antibody and gold particles is weak, and gold particles of 10 to 30 nm may not be attached. In this case, very small gold particles (nanogold particles) having particle diameters of the order of nanometers are first attached to the antibody. Under this condition, the gold particles are too small and it is difficult to observe them by SEM. Silver is adsorbed around the gold particles by making use of silver sensitization. This makes it easier to detect them by SEM.

In the foregoing, cells previously cultured in a laboratory dish are taken out and grafted onto the sample holder 40. Then, the cells are cultured. Alternatively, cells may be taken from a living organism and directly placed on the sample-holding surface 37a of the sample holder 40. The cells may be cultured in the sample holder 40.

During observation with the SEM under the condition where the shutter 4 is opened as shown in Fig. 1, if the sample-holding film 32 is broken, the liquid sample 20 flows into the vacuum chamber 11, increasing the pressure. If the vacuum gauge 15 has detected the increased pressure to be higher than 100 Pa, for example, information about it is sent to the electron beam controller 24, and an instruction for closing the shutter 4 is sent to the shutter actuator 14. As a result, the shutter 4 is closed as shown in Fig. 3. The liquid sample 20 is received and stopped by the shutter 4. Assuming cases where the liquid sample 20 intruding into the vacuum chamber 11 is large in quantity, the shutter 4 is fitted with the receiver dish 5 as shown in Fig. 2.

It takes only 0.1 second or less until the shutter 4 is closed after detection of a pressure rise. The contamination of the electron optical column 1 can be reduced to a level at which no cleaning is necessary. In this way, the present invention can enhance convenience in use of the apparatus.

In this way, use of the present invention makes it possible to perform SEM imaging of a submerged specimen using the sample-holding film 32. Especially, the use of the open sample chamber permits access to the sample from the outside and thus a stimulus can be easily given to cells.

In the present invention, the inverted type SEM is used. Depending on samples, a normal non-inverted type SEM using a sealed sample capsule as described in the "Description of the Related Art" of this specification can be used without problem. In this case, also, the shutter 4 needs to be located between the sealed sample capsule and the front end of the electron optical column 1.

In the above embodiments, an electron beam is used as the primary beam. If the sample-holding film 32 shows sufficient shock resistance and strength against impingement of other charged particle beam such as a helium ion beam, the invention can also be applied in a case where the other charged particle beam is used.

In the above embodiments, backscattered electrons are used as a secondary beam. Information about the cells 38 can also be obtained by detecting other form of information such as secondary electrons, X-rays, cathodoluminescent light, and electric current absorbed into the cells 38 forming a specimen. It is convenient to use the manipulator 26 in measuring the absorption current.

It is required that the sample-holding film 32 of the present embodiment withstand a pressure difference of at least 1 atm. and that gas or liquid do not flow in or out. Specifically, the material of the film 32 includes at least one of polymer, polyethylene, polyimide, polypropylene, carbon, silicon oxide, silicon nitride, and boron nitride.

The present embodiment is also well suited for applications where cells are cultured with the sample holder 40 and fixed using glutaraldehyde or formaldehyde and then the cells are stained to facilitate observation on the optical microscope or SEM.

As described so far, a function of producing a tertiary beam in response to a secondary beam arising from a specimen is imparted to the shutter. Furthermore, the shutter is fitted with the receiver dish. Therefore, if the sample-holding film 32 is destroyed, a large amount of liquid can be received and stopped by the receiver dish. At this time, the shutter and the receiver dish are wetted and contaminated. Consequently, the shutter needs to be cleaned or replaced. Because the shutter is simple in structure, it can be easily cleaned, and a cost reduction can be achieved if the shutter is replaced.

In this way, the inspection apparatus of the present invention has: the film 32 including the first surface 32a on which a sample is to be held; the vacuum chamber 11 for reducing the pressure in the ambient in contact with the second surface 32b of the film 32; the primary beam irradiation means 1 for irradiating the sample held on the film 32 with the primary beam 7 via the film 32, the primary beam irradiation means being connected with the vacuum chamber 11; the shutter 4 located between the film 32 and the primarybeam irradiation means 1 in the vacuum chamber 11 and configured to pass the primary beam 7 coming from the primary beam irradiation means 1, the shutter partially partitioning the space between the film 32 and the primary beam irradiation means 1 in the vacuum chamber; and the signal detection means 15 for detecting a tertiary signal produced from the shutter 4 when a secondary beam (such as backscattered electrons) emanating from the sample in response to the primary beam 7 passes through the film 32 and reaches the shutter 4.

The inspection method of the present invention is implemented to inspect a sample with the above-described inspection apparatus.

An inspection method according to the present invention includes the steps of: holding a sample on the first surface 32a of the film 32; reducing the pressure of the ambient in contact with the second surface 32b of the film 32; irradiating the sample with the primary beam 7 via the film 32 by the primary beam irradiation means 1 from a side of the second surface 32b of the film 32; causing a secondary beam such as backscattered electrons produced from the sample in response to the irradiation by the primary beam 7 to be directed at the shutter 4 that partially partitions the space between the film 32 and the primary beam irradiation means 1; and detecting a tertiary signal produced concomitanly from the shutter 4.

The shutter 4 used in the inspection apparatus and method described above is provided with the hole 4a such that it passes the primary beam 7 as described previously. Furthermore, the shutter 4 has the receiver dish 5. The first surface 32a of the film 32 holds a sample while in an open state to permit access to the sample.

The inspection apparatus has the destruction detection means 15 for detecting destruction of the film 32. When destruction of the film 32 is detected by the film destruction detecting means 15, the inspection apparatus moves the shutter 4 to block the path along which the primary beam 7 is directed at the film 32 from the primary beam irradiation means 1 in the space located inside the vacuum chamber 11. The destruction detecting means 15 detects a rise in the pressure inside the vacuum chamber 11 caused by destruction of the film 32.

The first surface 32a of the film 32 is the upper surface of the film 32, while the second surface 32b of the film 32 is the lower surface of the film 32.

The primary beam is a beam of charged particles or an electron beam. The secondary beam can be at least one type of secondary electrons, backscattered electrons, X-rays, and cathodoluminescent light. The tertiary signal can be at least one type of secondary electrons, backscattered electrons, X-rays, and cathodoluminescent light.

In this structure, if the film 32 is broken and the liquid sample 20 held on the film 32 flows into the vacuum chamber 11, the shutter 4 quickly partitions the primary beam irradiation means 1 and the film 32 from each other. Consequently, contamination of the primary beam irradiation means 1 due to the sample 20 can be prevented. At this time, the shutter 4 is contaminated but it may be cleaned or replaced.

Because the shutter 4 is simple in structure, a cost reduction can be achieved. In the past, whenever the film 32 was damaged or destroyed, the inside of the apparatus needed to be cleaned. The present invention facilitates or dispenses with the cleaning using a part replacement.

## Claims

1. An inspection apparatus comprising:
a film including a first surface on which a sample is to be held;
a vacuum chamber for reducing the pressure in an ambient in contact with a second surface of the film;
primary beam irradiation means for irradiating the sample held on the film with a primarybeamvia the film, the primary beam irradiation means being connected with the vacuum chamber;
a shutter located between the film and the primary beam irradiation means in the vacuum chamber and configured to pass the primary beam coming from the primary beam irradiation means, the shutter partially partitioning a space between the film and the primary beam irradiation means in the vacuum chamber; and
signal detection means for detecting a tertiary signal produced from the shutter when a secondary beam emanating from the sample in response to the primary beam passes through the film and reaches the shutter.

2. An inspection apparatus as set forth in claim 1, wherein said shutter is provided with a hole such that the shutter is configured to pass the primary beam.

3. An inspection apparatus as set forth in any one of claims 1 and 2, wherein said shutter has a receiver dish.

4. An inspection apparatus as set forth in any one of claims 1 to 3, wherein said first surface of the film holds the sample while in an open state to permit access to sample.

5. An inspection apparatus as set forth in any one of claims 1 to 4, wherein there is further provided destruction detection means for detecting destruction of said film, and wherein when destruction of the film has been detected by the destruction detection means, said shutter is moved to block a path along which the primary beam is directed from the primary beam irradiation means toward the film within the space.

6. An inspection apparatus as set forth in claim 5, wherein said destruction detection means detects a rise in the pressure inside said vacuum chamber caused by destruction of the film.

7. An inspection apparatus as set forth in any one of claims 1 to 6, wherein said first surface of the film is an upper surface of the film, while said second surface of the film is a lower surface of the film.

8. An inspection apparatus as set forth in any one of claims 1 to 7,
wherein said primary beam is a charged particle beam or an electron beam,
wherein said secondary beam is at least one type of secondary electrons, backscattered electrons, X-rays, and cathodoluminescent light, and
wherein said tertiary signal is at least one type of secondary electrons, backscattered electrons, X-rays, and cathodoluminescent light.

9. A method of inspecting a sample by the use of an inspection apparatus as set forth in any one of claims 1 to 8.

10. An inspection method comprising the steps of:
holding a sample on a first surface of a film;
reducing the pressure of an ambient in contact with a second surface of the film;
irradiating the sample with a primary beam via the film by a primary beam irradiation means from a side of the second surface of the film;
causing a secondary beam produced from the sample in response to the irradiation by the primary beam to be directed at a shutter that partially partitions a space between the film and the primary beam irradiation means; and
detecting a tertiary signal produced concomitantly from the shutter.

11. An inspection method as set forth in claim 10, wherein said shutter is provided with a hole to permit passage of the primary beam.

12. An inspection method as set forth in any one of claims 10 and 11, wherein said shutter has a receiver dish.

13. An inspection method as set forth in any one of claims 10 to 12, wherein said first surface of the film holds the sample while in an open state to permit access to the sample.

14. An inspection method as set forth in any one of claims 10 to 13, wherein when destruction of the film has been detected, said shutter is moved to block a path along which the primary beam is directed from the primary beam irradiation means toward the film within the space.

15. An inspection method as set forth in claim 14, wherein destruction of the film is detected by detecting a rise in the pressure in the ambient in contact with the second surface of the film.

16. An inspection method as set forth in any one of claims 10 to 15, wherein said first surface of the film is an upper surface of the film, while said second surface of the film is a lower surface of the film.

17. An inspection method as set forth in any one of claims 10 to 16,
wherein said primary beam is a charged particle beam or an electron beam,
wherein said secondary beam is at least one type of secondary electrons, backscattered electrons, X-rays, and cathodoluminescent light, and
wherein said tertiary signal is at least one type of secondary electrons, backscattered electrons, X-rays, and cathodoluminescent light.
